# EUROPEAN PATENT APPLICATION

(11) **EP 4 776 780 A2**
(43) Date of publication of application: **15.07.2026**
(21) Application number: 25212910.1
(22) Date of filing: 03.11.2025
(51) Int. Cl.: H10B 12/00, H10D 84/83

(54) **MEMORY DEVICE**

(30) Priority: 06.01.2025 KR 20250001568
(71) Applicant: SK hynix Inc., Bubal-eub Icheon-si Gyeonggi-do 17336 (KR)
(72) Inventor: CHANG, Heon Yong, 17336 Icheon-si, Gyeonggi-do (KR)
(74) Representative: Isarpatent

(57) **Abstract**

A memory device according to some embodiments of the present disclosure may comprise a substrate including a cell region and a peripheral region, a first transistor disposed in the peripheral region of the substrate, the first transistor comprising a first gate insulating layer, a first gate electrode, and a first gate capping layer and a second transistor disposed in the peripheral region of the substrate, the second transistor comprising a semiconductor layer, a second gate insulating layer having a lower surface positioned higher than a lower surface of the first gate insulating layer, a second gate electrode, and a second gate capping layer having an upper surface positioned at the same height as an upper surface of the first gate capping layer.

## Description

### TECHNICAL FIELD

The embodiments of the present disclosure relate generally to semiconductor technology and, more in particular to a memory device.

### BACKGROUND

Owing to features such as miniaturization, multifunctionality, and/or low manufacturing costs, memory devices have emerged as critical components in the electronics industry. As the electronics industry has advanced, memory devices have become increasingly integrated. To achieve higher integration of memory devices, the line width of wirings included in memory devices has gradually decreased, resulting in increased complexity of the processes used to fabricate the memory devices.

### SUMMARY

Various embodiments of the present disclosure provide a memory device in which interference between adjacent metal layers is minimized.

It should be noted that the embodiments of the present disclosure are not limited to those mentioned in this specification, and additional embodiments not explicitly mentioned can be clearly understood by those skilled in the art from the following descriptions.

According to an embodiment of the present disclosure a memory device may comprise a substrate including a cell region and a peripheral region; a first transistor disposed in the peripheral region of the substrate, the first transistor including a first gate insulating layer, a first gate electrode, and a first gate capping layer; and a second transistor disposed in the peripheral region of the substrate, the second transistor including a semiconductor layer, a second gate insulating layer having a lower surface positioned higher than a lower surface of the first gate insulating layer, a second gate electrode, and a second gate capping layer having an upper surface positioned substantially at the same height as an upper surface of the first gate capping layer.

According to another embodiment of the present disclosure a memory device may comprise a substrate including a cell region and a peripheral region; a first gate structure disposed in the peripheral region of the substrate, the first gate structure including a first gate insulating layer, a first gate electrode, and a first gate capping layer; a second gate structure disposed in the peripheral region of the substrate, the second gate structure including a second gate insulating layer, a second gate electrode, and a second gate capping layer, and having a thickness thinner than that of the first gate structure; and a semiconductor layer positioned between the substrate and the second gate structure.

According to another embodiment of the present disclosure, a memory device may comprise first and second transistors disposed over adjacent active regions of a substrate, the first transistor including a first gate insulating layer, a first gate electrode, and a first gate capping layer, the second transistor including a semiconductor layer, a second gate insulating layer having a lower surface positioned higher than a lower surface of the first gate insulating layer, a second gate electrode, and a second gate capping layer having an upper surface positioned substantially at the same height as an upper surface of the first gate capping layer, wherein a thickness of the second gate electrode is thinner than a thickness of the first gate electrode.

A memory device according to some embodiments of the present disclosure exhibits significantly reduced interference between adjacent metal layers. Importantly, interference between adjacent metal layers may be minimized or eliminated all-together.

These and other features, advantages, and effects of the embodiments of the present disclosure will become better understood from the following drawings and detailed description. It is further noted that the various effect may not be limited only to the effects expressly described herein, and that other or additional effects may be understood by those skilled in the art from the description and the claims.

### BRIEF DESCRIPTION OF THE DRAWINGS

The embodiments of the present disclosure will be more fully understood from the detailed description and accompanying drawings provided below. The detailed description and drawings are provided solely for illustration and are not intended to limit the scope of the present disclosure.
FIG. 1 illustrates a planar configuration of a memory device according to some embodiments of the present disclosure.
FIG. 2 illustrates a cross-sectional configuration of a memory device according to some embodiments of the present disclosure.
FIG. 3 and Fig. 4 illustrate other cross-sectional configurations of a memory device according to some embodiments of the present disclosure.
FIG. 5 to FIG. 14 illustrate methods of manufacturing a memory device according to embodiments of the present disclosure.
FIG. 15 to FIG. 18 illustrate other methods of manufacturing a memory device according to embodiments of the present disclosure.

### DETAILED DESCRIPTION

Hereinafter, embodiments of the present disclosure are described in detail with reference to the accompanying drawings. In assigning reference numerals to components in each drawing, identical components may be assigned the same reference numerals even when shown in different drawings. If details of known art or functions are deemed to obscure the subject matter of this disclosure, such details may be omitted. As used herein, terms such as "includes," "has," or "is composed of" in relation to a component may permit the inclusion of additional components unless terms like "only" are explicitly used. Additionally, unless the context clearly indicates otherwise, expressions in the singular, such as "a," "an," and "the" are intended to include their plural forms.

Labels such as "first," "second," "A," "B," "(a)," and "(b)" may be used to describe components of this disclosure. These labels are intended merely to distinguish one component from another, and are not intended to limit the nature, order, sequence, or number of the components.

Regarding the description of positional relationships between components, when two or more components are described as being "connected," "coupled," or "linked," it should be understood that they may be directly "connected," "coupled," or "linked," or may have an intervening component. Here, the intervening component may be included in one or more of the two or more components that are "connected," "coupled," or "linked" to each other.

When terms such as "after," "next to," "subsequent to" or "before," are used to describe the temporal or sequential relationships between components, operation methods, or fabrication methods, they may also encompass a non-continuous case unless terms like "immediately" or "directly" are explicitly used.

When a component is associated with a value or its corresponding information (e.g., level), such value or information may be interpreted to include tolerances arising due to various factors (e.g., process variations, internal or external impacts, or noise), even without explicit separate descriptions.

Hereinafter, various embodiments of the present disclosure will be described in detail with reference to accompanying drawings.

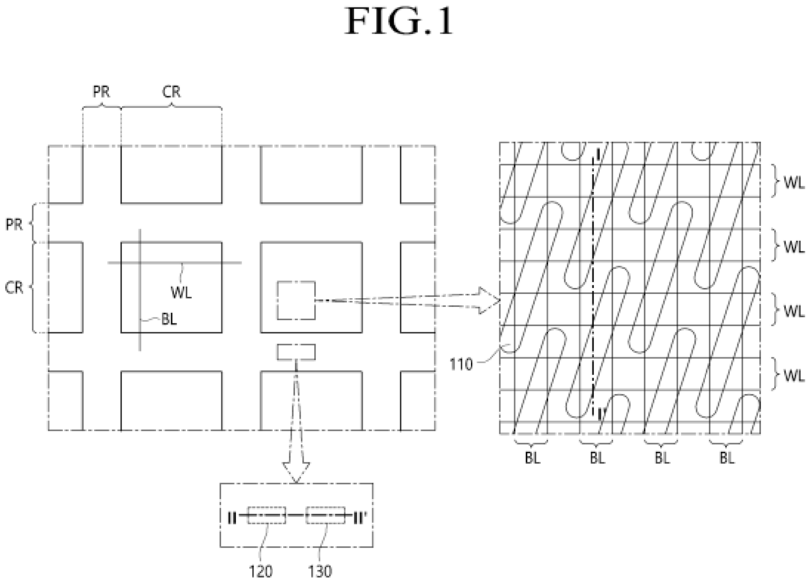

FIG. 1 illustrates a planar configuration of a memory device according to some embodiments of the present disclosure.

Referring to FIG. 1, the memory device includes a cell region (CR) and a peripheral region (PR). The cell region (CR) is a region where memory cells are arranged. The peripheral region (PR) is a region where peripheral circuits for delivering various voltages or signals to the memory cells arranged in the cell region (CR) are arranged. The peripheral region (PR) is arranged around the cell region (CR). According to an embodiment, the peripheral region (PR) may surround the cell region (CR).

The memory device includes bit lines (BL), word lines (WL), and active regions 110, 120 and 130. The active regions 110, 120 and 130 include a first active region 110, a second active region 120 and a third active region 130.

The first active region 110 is located in the cell region (CR). The first active regions 110 are arranged spaced apart from each other. The bit lines (BL) and word lines (WL) are arranged to traverse the first active region 110. According to an embodiment, a single bit line (BL) may traverse a single first active region 110. In another embodiment, two word lines (WL) may traverse the single first active region 110. The bit lines (BL) and word lines (WL) are arranged to overlap the cell region (CR). The bit lines (BL) and word lines (WL) may extend to the peripheral region (PR).

The second active region 120 and the third active region 130 are located in the peripheral region (PR). The second active region 120 and the third active region 130 are arranged spaced apart from each other.

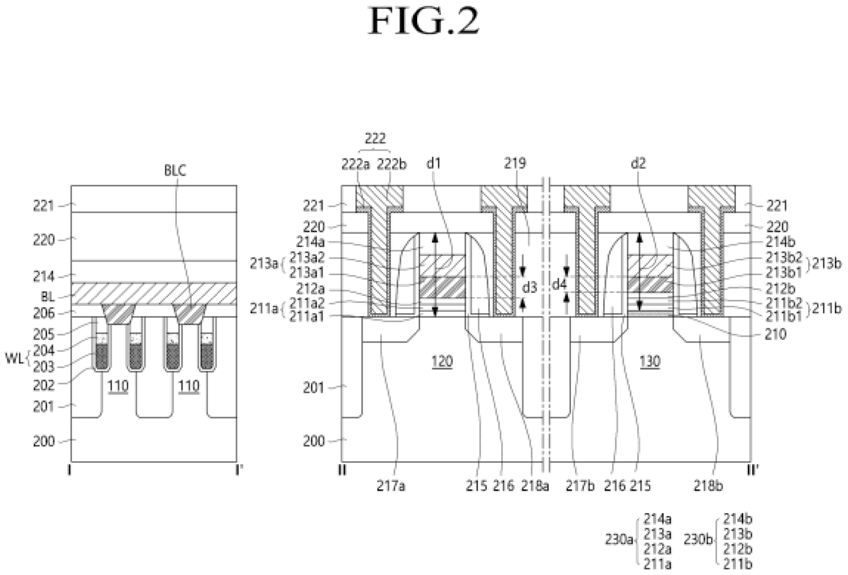

FIG. 2 illustrates a cross-sectional configuration of a memory device according to some embodiments of the present disclosure.

Referring to FIG. 2, the memory device includes a substrate 200, a device isolation layer 201, a first transistor, a second transistor, a cell gate insulating layer 202, a word line (WL), a word line capping layer 205, a first insulating layer 206, a bit line contact (BLC), a bit line (BL), a bit line capping layer 214, a first spacer 215, a second spacer 216, a second insulating layer 219, a third insulating layer 220, and a fourth insulating layer 221.

Referring to FIG. 1 and FIG. 2, the substrate 200 includes a cell region (CR) and a peripheral region (PR). In the cell region (CR), the device isolation layer 201 defining the first active region 110 is arranged within the substrate 200. The substrate 200 may include a semiconductor substrate such as a silicon wafer or an SOI (Silicon On Insulator) wafer. The substrate 200 may include a Group III-V semiconductor substrate, such as a compound semiconductor substrate like gallium arsenide (GaAs). The substrate 200 may include single-crystal silicon, polysilicon, amorphous silicon, single-crystal silicon-germanium, polycrystalline silicon-germanium, carbon-doped silicon, or combinations thereof. According to an embodiment, the substrate 200 may be silicon doped with a Group III element.

In the first active region 110 of the substrate 200, word lines (WL) are embedded. The word lines (WL) may also be referred to as embedded word lines or embedded gates. The word lines (WL) include a first word line 203 and a second word line 204. The second word line 204 may be disposed over the first word line 203. A word line capping layer 205 is disposed on the word lines (WL). A cell gate insulating layer 202 surrounds the word lines (WL), and the word line capping layer 205. The cell gate insulating layer 202 surrounds the sides and bottom surfaces of the word lines (WL). The cell gate insulating layer 202 is positioned between the word lines (WL) and the substrate 200 and, also, between the word line capping layer 205, and the substrate 200. The word lines (WL) may comprise conductive materials such as metals, metal nitrides, metal silicides, polysilicon, conductive carbon, or combinations thereof. The cell gate insulating layer 202 may include silicon oxide, silicon nitride, silicon oxynitride, high-k dielectric materials, or combinations thereof. The word line capping layer 205 may comprise silicon nitride.

A first insulating layer 206 is arranged on the substrate 200. The first insulating layer 206 is depicted as a single layer but may be composed of two or more layers. The first insulating layer 206 may include silicon oxide or silicon nitride.

The bit line contact (BLC) passes through the first insulating layer 206 to contact the first active region 110 of the substrate 200. The bottom of the bit line contact (BLC) may be positioned below the upper surface of the substrate 200. According to an embodiment, two word lines (WL) may be positioned between two bit line contacts (BLC). According to an embodiment, the bit line contact (BLC) may include polysilicon.

A bit line (BL) and a bit line capping layer 214 are sequentially arranged on the bit line contact (BLC) and the first insulation layer 206. The bit line (BL) may include tungsten (W), molybdenum (Mo), gold (Au), copper (Cu), aluminum (Al), nickel (Ni), or cobalt (Co). The bit line (BL) may further include a barrier material. The barrier material may include WNx, WSiN, Ta, Ti, TiN, Mg, Sr, or combinations thereof. According to an embodiment, the bit line (BL) may include the same material as the first upper gate electrode 213a2 and the second upper gate electrode 213b2. The bit line capping layer 214 may include silicon nitride. According to an embodiment, the bit line capping layer 214 may include the same material as the first gate capping layer 214a and the second gate capping layer 214b.

A third insulating layer 220 is arranged on the bit line capping layer 214. A fourth insulating layer 221 is arranged on the third insulating layer 220. The third insulating layer 220 and the fourth insulating layer 221 may include silicon oxide.

Referring to FIG. 1 and FIG. 2, the device isolation layer 201 defining the second active region 120 and the third active region 130 is arranged within the substrate 200 in the peripheral region (PR).

A first transistor is arranged on the second active region 120 of the substrate 200. A second transistor is arranged on the third active region 130 of the substrate 200. The first transistor and the second transistor may be transistors included in the peripheral circuits. According to an embodiment, the first transistor may be an NMOS transistor, and the second transistor may be a PMOS transistor.

A first transistor includes a first gate structure 230a, a first source region 217a, and a first drain region 218a. A second transistor includes a semiconductor layer 210, a second gate structure 230b, a second source region 217b, and a second drain region 218b.

The first gate structure 230a includes a first gate insulating layer 211a, a first work function adjustment layer 212a, a first gate electrode 213a, and a first gate capping layer 214a. The second gate structure 230b includes a second gate insulating layer 211b, a second work function adjustment layer 212b, a second gate electrode 213b, and a second gate capping layer 214b.

The first gate insulating layer 211a comprises a first lower gate insulating layer 211a1 and a first upper gate insulating layer 211a2 disposed on the first lower gate insulating layer 211a1. The second gate insulating layer 211b comprises a second lower gate insulating layer 211b1 and a second upper gate insulating layer 211b2. The first gate electrode 213a comprises a first lower gate electrode 213a1 and a first upper gate electrode 213a2. The second gate electrode 213b comprises a second lower gate electrode 213b1 and a second upper gate electrode 213b2 disposed on the second lower gate electrode 213b1.

The first gate structure 230a contacts the upper surface of the substrate 200. The second gate structure 230b is spaced apart from the upper surface of the substrate 200. A semiconductor layer 210 is positioned between the second gate structure 230b and the substrate 200.

A first lower gate insulating layer 211a1 is disposed on the second active region 120 of the substrate 200. The first lower gate insulating layer 211a1 may include silicon oxide, silicon nitride, silicon oxynitride, or combinations thereof.

A first upper gate insulating layer 211a2 is disposed on the first lower gate insulating layer 211a1. According to an embodiment, the first upper gate insulating layer 211a2 may comprise a material with a higher dielectric constant than that of the first lower gate insulating layer 211a1. The first upper gate insulating layer 211a2 may include high-k materials, silicon oxide, silicon nitride, silicon oxynitride, or combinations thereof. For example, the high-k material may include hafnium oxide (HfO2), hafnium silicate (HfSiO), lanthanum oxide (LaO), hafnium silicate nitride (HfSiON), or combinations thereof.

A first work function adjustment layer 212a is disposed on the first upper gate insulating layer 211a2. The first work function adjustment layer 212a may include metal, metal nitride, metal carbide, conductive materials containing metal atoms, or combinations thereof. According to an embodiment, the first work function adjustment layer 212a may include titanium nitride (TiN).

The first lower gate electrode 213a1 is disposed on the first work function adjustment layer 212a. The first lower gate electrode 213a1 may include metal, metal silicide, metal nitride, metal oxide, polysilicon, conductive carbon, or combinations thereof. According to an embodiment, the first lower gate electrode 213a1 may include doped polysilicon.

The first upper gate electrode 213a2 is disposed on the first lower gate electrode 213a1. The first upper gate electrode 213a2 may include metal, metal silicide, metal nitride, metal oxide, polysilicon, conductive carbon, or combinations thereof. According to an embodiment, the first upper gate electrode 213a2 may include tungsten (W), molybdenum (Mo), gold (Au), copper (Cu), aluminum (Al), nickel (Ni), titanium (Ti), or cobalt (Co). The first upper gate electrode 213a2 may further include a barrier material. The barrier material may include tungsten nitride (WNx), tungsten silicon nitride (WSiN), tantalum(Ta), titanium(Ti), titanium nitride (TiN), magnesium(Mg), strontium(Sr), or combinations of these.

The first gate capping layer 214a is disposed on the first upper gate electrode 213a2. The first gate capping layer 214a may include silicon nitride.

A semiconductor layer 210 is disposed on the third active region 130 of the substrate 200. The semiconductor layer 210 may be an epitaxial layer. For example, the semiconductor layer 210 may be a layer epitaxially grown on the substrate 200. According to an embodiment, the semiconductor layer 210 may include silicon germanium (SiGe).

A second lower gate insulating layer 211b1 is disposed on the semiconductor layer 210. The second lower gate insulating layer 211b1 is spaced apart from the substrate 200. The lower surface of the second lower gate insulating layer 211b1 may be positioned higher than the lower surface of the first lower gate insulating layer 211a1. The second lower gate insulating layer 211b1 may include silicon oxide, silicon nitride, silicon oxynitride, or combinations thereof.

A second upper gate insulating layer 211b2 is disposed on the second lower gate insulating layer 211b1. According to an embodiment, the second upper gate insulating layer 211b2 may include a material with a higher dielectric constant than the second lower gate insulating layer 211b1. The second upper gate insulating layer 211b2 may include high-k materials, silicon oxide, silicon nitride, silicon oxynitride, or combinations thereof. For example, high-k materials may include hafnium oxide (HfO2), hafnium silicate (HfSiO), lanthanum oxide (LaO), or hafnium silicate nitride (HfSiON), or combinations thereof.

The second work function adjustment layer 212b is disposed on the second upper gate insulating layer 211b2. The second work function adjustment layer 212b may include metal, metal nitride, metal carbide, conductive materials containing metal atoms, or combinations thereof. According to an embodiment, the second work function adjustment layer 212b may include titanium nitride (TiN).

The second lower gate electrode 213b1 is disposed on the second work function adjustment layer 212b. In some embodiments of the present disclosure, the thickness (d4) of the second lower gate electrode 213b1 may be thinner than the thickness (d3) of the first lower gate electrode 213a1. In some embodiments of the present disclosure, the upper surface of the second lower gate electrode 213b1 may be substantially at the same height as the upper surface of the first lower gate electrode 213a1. The second lower gate electrode 213b1 may include metal, metal silicide, metal nitride, metal oxide, polysilicon, conductive carbon, or combinations thereof. According to an embodiment, the second lower gate electrode 213b1 may include doped polysilicon.

The second upper gate electrode 213b2 is disposed on the second lower gate electrode 213b1. The thickness of the second upper gate electrode 213b2 may be substantially the same as that of the first upper gate electrode 213a2. The upper surface of the second upper gate electrode 213b2 may be substantially at the same height as the upper surface of the first upper gate electrode 213a2. The second upper gate electrode 213b2 may include metal, metal silicide, metal nitride, metal oxide, polysilicon, conductive carbon, or combinations thereof. According to an embodiment, the second upper gate electrode 213b2 may include tungsten (W), molybdenum (Mo), gold (Au), copper (Cu), aluminum (Al), nickel (Ni), titanium (Ti), or cobalt (Co). The second upper gate electrode 213b2 may further include a barrier material. The barrier material may include WNx, WSiN, Ta/TiN, Ti/TiN, Mg/TiN, Sr/TiN, or combinations thereof.

The second gate capping layer 214b is disposed on the second upper gate electrode 213b2. The second gate capping layer 214b may include silicon nitride. The thickness of the second gate capping layer 214b may be substantially the same as that of the first gate capping layer 214a. In some embodiments of the present disclosure, the upper surface of the second gate capping layer 214b may be positioned at substantially the same height as the upper surface of the first gate capping layer 214a.

In some embodiments of the present disclosure, the thickness (d1) of the first gate structure 230a may be thicker than the thickness (d2) of the second gate structure 230b. The upper surface of the first gate structure 230a may be positioned at substantially the same height as the upper surface of the second gate structure 230b.

A first spacer 215 is disposed on the sidewalls of the first gate structure 230a and the second gate structure 230b. A second spacer 216 is disposed on the first spacer 215. The first spacer 215 and the second spacer 216 may each include silicon oxide, silicon nitride, silicon carbo-nitride, low-k materials, or combinations thereof.

A first source region 217a and a first drain region 218a are disposed in the second active region 120 of the substrate 200. The first source region 217a and the first drain region 218a may be doped with n-type impurities. For example, the n-type impurities may include phosphorus (P) or arsenic (As).

A second source region 217b and a second drain region 218b are disposed in the third active region 130 of the substrate 200. The second source region 217b and the second drain region 218b may be doped with p-type impurities. For example, the p-type impurities may include boron (B) or aluminum (Al).

A second insulating layer 219 is disposed on the substrate 200 and the second spacer 216. The second insulating layer 219 may cover the upper surface of the substrate 200 and the outer surface of the second spacer 216. The second insulating layer 219 may include silicon oxide. A third insulating layer 220 and a fourth insulating layer 221 are sequentially disposed on the second insulating layer 219.

A contact structure 222 is disposed on the first source region 217a, the first drain region 218a, the second source region 217b, and the second drain region 218b. The contact structure 222 is connected to each of the first source region 217a, the first drain region 218a, the second source region 217b, and the second drain region 218b. The contact structure 222 passes through the fourth insulating layer 221, the third insulating layer 220, and the second insulating layer 219 to connect to each of the first source region 217a, the first drain region 218a, the second source region 217b, and the second drain region 218b.

The contact structure 222 includes a contact barrier layer 222a and a contact conductive layer 222b. The contact barrier layer 222a may include titanium (Ti), titanium nitride (TiN), titanium silicon nitride (TiSiN), tantalum (Ta), tantalum nitride (TaN), tungsten nitride (WN), or combinations thereof. The contact conductive layer 222b may include metal, metal nitride, metal silicide, or combinations thereof. According to an embodiment, the contact conductive layer 222b may include tungsten (W) or tungsten compounds.

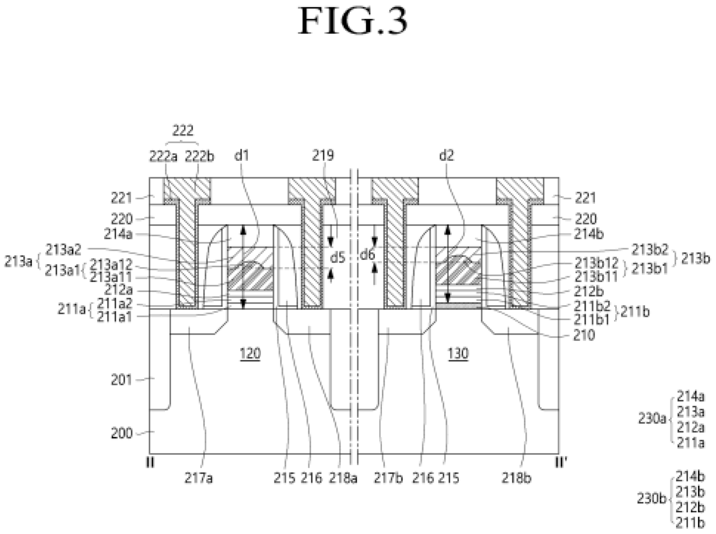

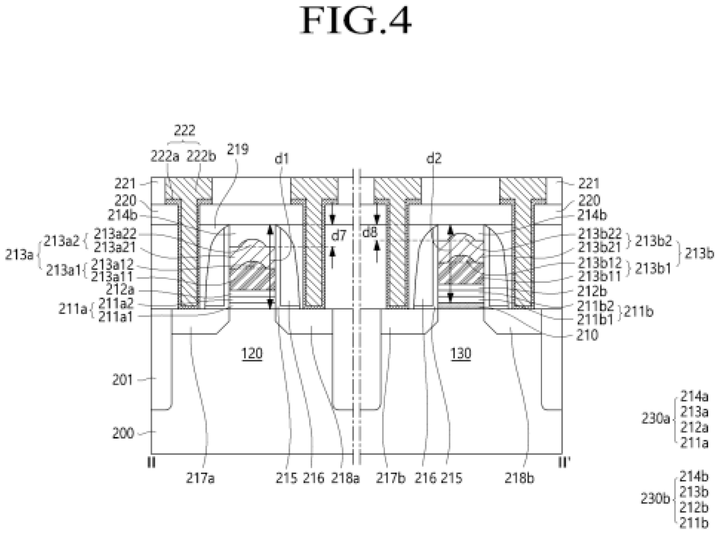

FIG. 3 and FIG. 4 illustrate other cross-sectional configurations of a memory device according to some embodiments of the present disclosure.

Referring to Figure 3, the first transistor includes a first gate structure 230a, a first source region 217a, and a first drain region 218a. The second transistor includes a semiconductor layer 210, a second gate structure 230b, a second source region 217b, and a second drain region 218b.

The first gate structure 230a includes a first gate insulating layer 211a, a first work function adjustment layer 212a, a first gate electrode 213a, and a first gate capping layer 214a. The second gate structure 230b includes a second gate insulating layer 211b, a second work function adjustment layer 212b, a second gate electrode 213b, and a second gate capping layer 214b.

The first gate insulating layer 211a comprises a first lower gate insulating layer 211a1 and a first upper gate insulating layer 211a2. The second gate insulating layer 211b comprises a second lower gate insulating layer 211b1 and a second upper gate insulating layer 211b2. The first gate electrode 213a comprises a first lower gate electrode 213a1 and a first upper gate electrode 213a2. The second gate electrode 213b comprises a second lower gate electrode 213b1 and a second upper gate electrode 213b2.

The first lower gate electrode 213a1 includes a first lower gate flat portion 213a11 and a first lower gate protruding portion 213a12. The first lower gate protruding portion 213a12 is located on the first lower gate flat portion 213a11. The first lower gate protruding portion 213a12 extends into the first upper gate electrode 213a2. The first lower gate protruding portion 213a12 may be spaced apart from the first gate capping layer 214a.

According to an embodiment, the first lower gate protruding portion 213a12 refers to a portion that protrudes above the upper surface of the first lower gate flat portion 213a11 due to various defects occurring during the formation of the first lower gate electrode 213a1. The shape of the first lower gate protruding portion 213a12 is depicted as semicircular but is not necessarily limited thereto and may vary depending on the type of defect.

The second lower gate electrode 213b1 includes a second lower gate flat portion 213b11 and a second lower gate protruding portion 213b12. The second lower gate protruding portion 213b12 is located on the second lower gate flat portion 213b11. The second lower gate protruding portion 213b12 extends into the second upper gate electrode 213b2. The second lower gate protruding portion 213b12 may be spaced apart from the second gate capping layer 214b.

According to an embodiment, the second lower gate protruding portion 213b12 refers to a portion that protrudes above the upper surface of the second lower gate flat portion 213b11 due to various defects occurring during the formation of the second lower gate electrode 213b1. The shape of the second lower gate protruding portion 213b12 is depicted as semicircular but is not necessarily limited thereto and may vary depending on the type of defect.

The thickness of the first lower gate flat portion 213a11 may be substantially the same as the thickness of the second lower gate flat portion 213b11. The upper surface of the second lower gate flat portion 213b11 may be positioned higher than the upper surface of the first lower gate flat portion 213a11.

In some embodiments of the present disclosure, the thickness (d5) of the first upper gate electrode 213a2 may be thicker than the thickness (d6) of the second upper gate electrode 213b2. In some embodiments of the present disclosure, the upper surface of the first upper gate electrode 213a2 may be positioned at substantially the same height as the upper surface of the second upper gate electrode 213b2.

The thickness of the first gate capping layer 214a may be substantially the same as the thickness of the second gate capping layer 214b. The upper surface of the first gate capping layer 214a may be positioned at substantially the same height as the upper surface of the second gate capping layer 214b.

The thickness (d1) of the first gate structure 230a may be thicker than the thickness (d2) of the second gate structure 230b.

Referring to FIG. 4, the first transistor includes a first gate structure 230a, a first source region 217a, and a first drain region 218a. The second transistor includes a semiconductor layer 210, a second gate structure 230b, a second source region 217b, and a second drain region 218b.

The first gate structure 230a includes a first gate insulating layer 211a, a first work function adjustment layer 212a, a first gate electrode 213a, and a first gate capping layer 214a. The second gate structure 230b includes a second gate insulating layer 211b, a second work function adjustment layer 212b, a second gate electrode 213b, and a second gate capping layer 214b.

The first gate insulating layer 211a comprises a first lower gate insulating layer 211a1 and a first upper gate insulating layer 211a2. The second gate insulating layer 211b comprises a second lower gate insulating layer 211b1 and a second upper gate insulating layer 211b2. The first gate electrode 213a comprises a first lower gate electrode 213a1 and a first upper gate electrode 213a2. The second gate electrode 213b comprises a second lower gate electrode 213b1 and a second upper gate electrode 213b2.

The first lower gate electrode 213a1 includes a first lower gate flat portion 213a11 and a first lower gate protruding portion 213a12. The second lower gate electrode 213b1 includes a second lower gate flat portion 213b11 and a second lower gate protruding portion 213b12. The first upper gate electrode 213a2 comprises a first upper gate flat portion 213a21 and a first upper gate protruding portion 213a22. The second upper gate electrode 213b2 comprises a second upper gate flat portion 213b21 and a second upper gate protruding portion 213b22.

The first upper gate protruding portion 213a22 extends into the first gate capping layer 214a. The upper surface of the first upper gate protruding portion 213a22 may be positioned lower than the upper surface of the first gate capping layer 214a.

According to an embodiment, the first upper gate protruding portion 213a22 refers to a portion that protrudes above the upper surface of the first upper gate flat portion 213a21 due to the first lower gate protruding portion 213a12 during the formation of the first upper gate electrode 213a2. The shape of the first upper gate protruding portion 213a22 is depicted as semicircular but is not necessarily limited thereto and may vary depending on the shape of the first lower gate protruding portion 213a12.

The second upper gate protruding portion 213b22 extends into the second gate capping layer 214b. The upper surface of the second upper gate protruding portion 213b22 may be positioned lower than the upper surface of the second gate capping layer 214b.

According to an embodiment, the second upper gate protruding portion 213b22 refers to a portion that protrudes above the upper surface of the second upper gate flat portion 213b21 due to the second lower gate protruding portion 213b12 during the formation of the second upper gate electrode 213b2. The shape of the second upper gate protruding portion 213b22 is depicted as semicircular but is not necessarily limited thereto and may vary depending on the shape of the second lower gate protruding portion 213b12.

The thickness of the first lower gate flat portion 213a11 may be substantially the same as the thickness of the second lower gate flat portion 213b11. The upper surface of the second lower gate flat portion 213b11 may be positioned higher than the upper surface of the first lower gate flat portion 213a11.

The thickness of the first upper gate flat portion 213a21 may be substantially the same as the thickness of the second upper gate flat portion 213b21. The upper surface of the second upper gate flat portion 213b21 may be positioned higher than the upper surface of the first upper gate flat portion 213a21.

In some embodiments of the present disclosure, the thickness (d7) of the first gate capping layer 214a may be thicker than the thickness (d8) of the second gate capping layer 214b. In some embodiments of the present disclosure, the upper surface of the first gate capping layer 214a may be positioned substantially at the same height as the upper surface of the second gate capping layer 214b.

The thickness (d1) of the first gate structure 230a may be thicker than the thickness (d2) of the second gate structure 230b.

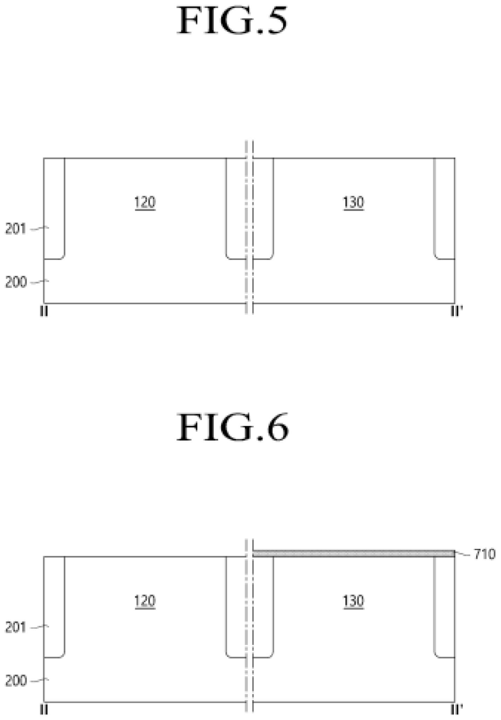

FIG. 5 to FIG. 14 illustrate diagrams of methods of manufacturing a memory device according to embodiments of the present disclosure.

Referring to FIG. 1 and FIG. 5, device isolation layer 201 defining a second active region 120 and a third active region 130 within the substrate 200 is formed. The second active region 120 and the third active region 130 are located in the peripheral region (PR). The device isolation layer 201 may include silicon oxide, silicon nitride, or combinations thereof.

Referring to FIG. 6, a semiconductor material layer 710 is formed on the third active region 130 of the substrate 200. The semiconductor material layer 710 may be a layer epitaxially grown on the upper surface of the substrate 200. According to an embodiment, the semiconductor material layer 710 may include silicon germanium.

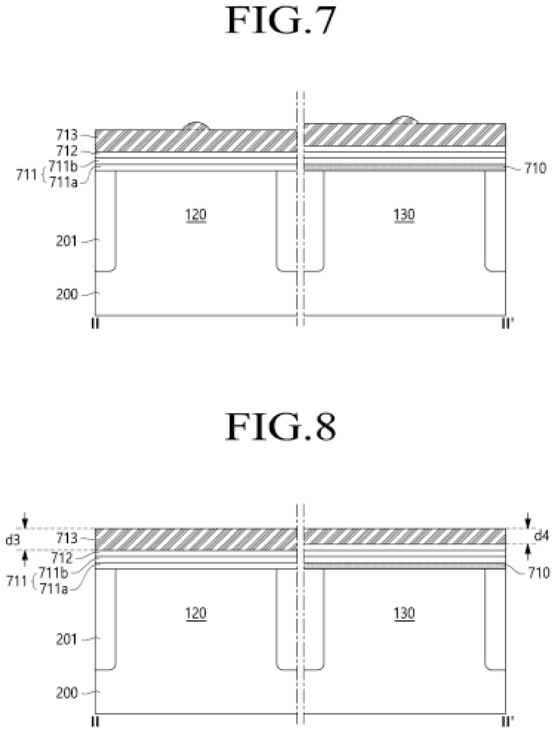

Referring to FIG. 7, a gate insulating material layer 711, a work function adjustment material layer 712, and a lower gate electrode material layer 713 are sequentially formed on the second active region 120 of the substrate 200 and the semiconductor material layer 710. The gate insulating material layer 711 includes a lower gate insulating material layer 711a and an upper gate insulating material layer 711b.

The lower gate insulating material layer 711a may include silicon oxide, silicon nitride, silicon oxynitride, or combinations thereof. The upper gate insulating material layer 711b may include high-k materials, silicon oxide, silicon nitride, silicon oxynitride, or combinations thereof. For example, the high-k material may include hafnium oxide (HfO), hafnium silicate (HfSiO), hafnium silicate nitride (HfSiON), or combinations thereof.

The work function adjustment material layer 712 may be made of metal, metal nitride, metal carbide, a conductor containing metal atoms, or combinations thereof. According to an embodiment, the work function adjustment material layer 712 may include titanium nitride (TiN).

The lower gate electrode material layer 713 may include metal, metal silicide, metal nitride, metal oxide, polysilicon, conductive carbon, or combinations thereof. According to an embodiment, the lower gate electrode material layer 713 may include doped polysilicon.

According to an embodiment, at least a portion of the lower gate electrode material layer 713 may protrude in a direction perpendicular to the upper surface of the substrate 200 in localized regions, such as the central regions of the second active region 120 and the third active region 130. According to an embodiment, the protrusion of a portion of the lower gate electrode material layer 713 may result from various defects that cause uneven deposition of the lower gate electrode material layer 713. While the shape of the protruding portion is illustrated as a semicircular, it is not necessarily limited thereto and may vary depending on the form of defect.

Referring to FIG. 8, the upper portion of the lower gate electrode material layer 713 is removed, for example, by a process including chemical mechanical polishing (CMP). According to an embodiment, this process may also remove the protruding portions of the lower gate electrode material layer (713).

In some embodiments of the present disclosure, the upper surface of the lower gate electrode material layer 713 overlapping the second active region 120 may be substantially coplanar with the upper surface of the lower gate electrode material layer 713 overlapping the third active region 130. In some embodiments of the present disclosure, the thickness (d3) of the lower gate electrode material layer 713 in the region overlapping the second active region 120 may be thicker than the thickness (d4) of the lower gate electrode material layer 713 in the region overlapping the third active region 130.

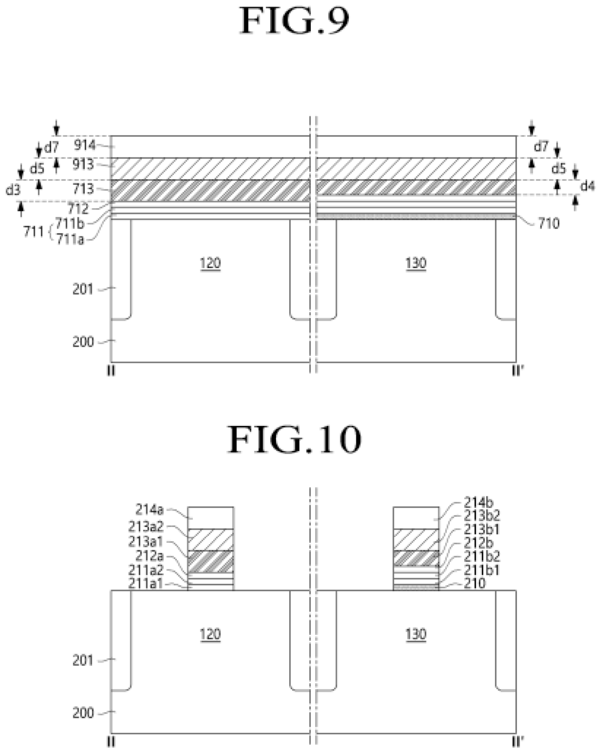

Referring to FIG. 9, an upper gate electrode material layer 913 and a gate capping material layer 914 are sequentially formed over the lower gate electrode material layer 713. The upper gate electrode material layer 913 is formed on the lower gate electrode material layer 713. The upper gate electrode material layer 913 may include metal, metal silicide, metal nitride, metal oxide, polysilicon, conductive carbon, or combinations thereof. According to an embodiment, the upper gate electrode material layer 913 may include tungsten (W), molybdenum (Mo), gold (Au), copper (Cu), aluminum (Al), nickel (Ni), or cobalt (Co). The upper gate electrode material layer 913 may further include a barrier material. The barrier material may include WNx, WSiN, Ta/TiN, Ti/TiN, Mg/TiN, Sr/TiN, or combinations thereof.

The thickness (d5) of the upper gate electrode material layer 913 may be substantially the same in the second active region 120 and the third active region 130. The thickness (d7) of the gate capping material layer 914 may also be substantially the same in the second active region 120 and the third active region 130.

In some embodiments of the present disclosure, the upper surface of the gate capping material layer 914 in the region overlapping the second active region 120 may be substantially coplanar with the upper surface of the gate capping material layer 914 in the region overlapping the third active region 130.

Referring to FIG. 9 and FIG. 10, at least a portion of the semiconductor material layer 710, the gate insulating material layer 711, the work function adjustment material layer 712, the lower gate electrode material layer 713, the upper gate electrode material layer 913, and the gate capping material layer 914 are removed in regions overlapping the second active region 120 and the third active region 130.

As at least a portion of the semiconductor material layer 710 is removed, a semiconductor layer 210 is formed in the region overlapping the third active region 130. As at least a portion of the lower gate insulating material layer 711a is removed, a first lower gate insulating layer 211a1 and a second lower gate insulating layer 211b1 are formed. Similarly, in the region overlapping the second active region 120, a first upper gate insulating layer 211a2, a first lower gate electrode 213a1, a first upper gate electrode 213a2, and a first gate capping layer 214a are formed. Similarly, in the region overlapping the third active region 130, a second upper gate insulating layer 211b2, a second lower gate electrode 213b1, a second upper gate electrode 213b2, and a second gate capping layer 214b are formed.

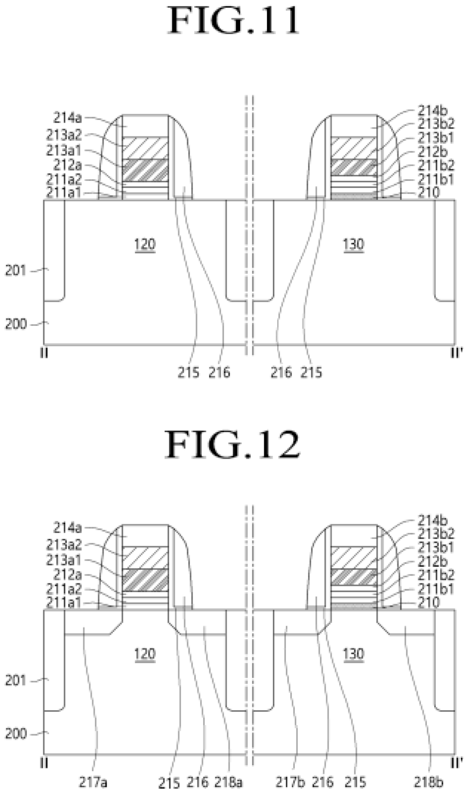

Referring to FIG. 11, a first spacer 215 is formed on the sidewalls of the first lower gate insulating layer 211a1, the first upper gate insulating layer 211a2, the first work function adjustment layer 212a, the first lower gate electrode 213a1, the first upper gate electrode 213a2, the first gate capping layer 214a, the semiconductor layer 210, the second lower gate insulating layer 211b1, the second upper gate insulating layer 211b2, the second work function adjustment layer 212b, the second lower gate electrode 213b1, the second upper gate electrode 213b2, and the second gate capping layer 214b. A second spacer 216 is formed on the sidewalls of the first spacer 215.

Referring to FIG. 12, a first source region 217a and a first drain region 218a are formed in the second active region 120 of the substrate 200. Similarly, a second source region 217b and a second drain region 218b are formed in the third active region 130. The first source region 217a and the first drain region 218a may be doped with N-type impurities. The second source region 217b and the second drain region 218b may be doped with P-type impurities.

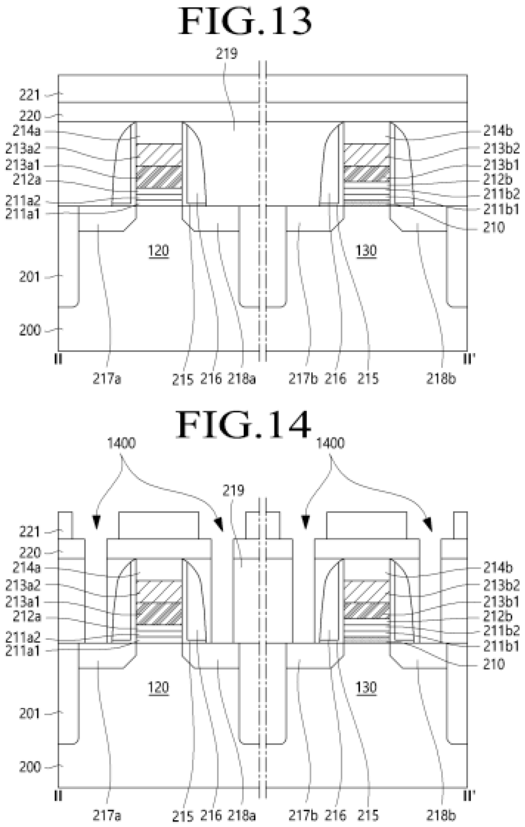

Referring to FIG. 13, a second insulating layer 219 is formed covering the upper surface of the substrate 200 and the outer sidewalls of the second spacer 216. The second insulating layer 219 may also cover the upper surface of the first spacer 215. A third insulating layer 220 and a fourth insulating layer 221 are sequentially formed on the second insulating layer 219.

Referring to FIG. 14, a via hole 1400 is formed, penetrating (passing through) the second insulating layer 219, the third insulating layer 220, and the fourth insulating layer 221. A plurality of via holes 1400 may be formed. The via holes 1400 may be positioned to expose the first source region 217a, the first drain region 218a, the second source region 217b, and the second drain region 218b.

Referring to FIG. 2 and FIG. 14, conductive material is deposited in the via hole 1400, forming a contact barrier layer 222a and a contact conductive layer 222b in sequence. The contact barrier layer 222a and the contact conductive layer 222b constitute the contact structure 222.

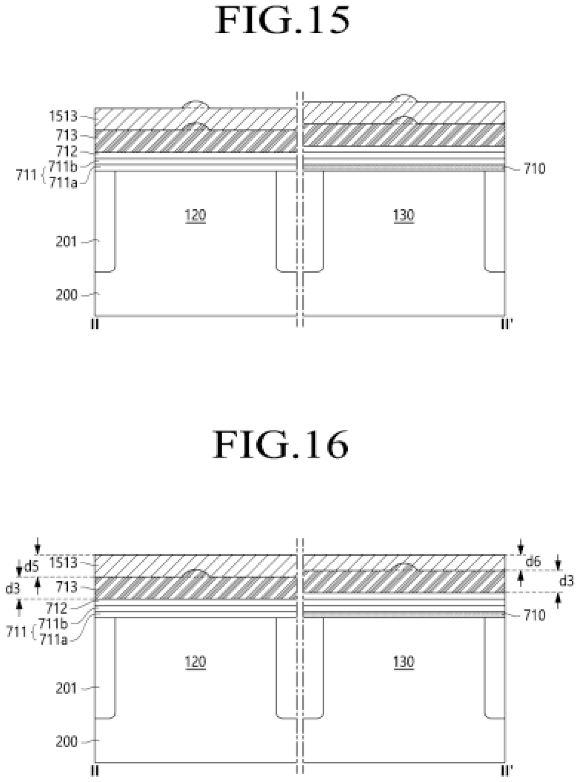

FIG. 15 to FIG. 18 illustrate other methods of manufacturing a memory device according to embodiments of the present disclosure.

The memory device shown in FIG. 15 may be formed using substantially the same method as the method of manufacturing a memory device described with reference to FIG. 5 to FIG. 7.

Referring to FIG. 15, an upper gate electrode material layer 1513 is formed on the lower gate electrode material layer 713. In localized regions, for example, the central regions of the second active region 120 and the third active region 130, at least a portion of the upper gate electrode material layer 1513 may protrude in a direction perpendicular to the upper surface of the substrate 200. The shape of the protruding portion is illustrated as semicircular but is not necessarily limited thereto and may vary depending on the shape of the lower gate electrode material layer 713. The protrusions on the upper gate electrode material layer 1513 may be positioned to overlap with the protrusions on the lower gate electrode material layer 713.

Referring to FIG. 16, the upper portion of the upper gate electrode material layer 1513 is removed. According to an embodiment, the process of removing the upper portion of the upper gate electrode material layer 1513 may include a chemical mechanical polishing process. According to an embodiment, this process may also remove the protruding portions of the upper gate electrode material layer 1513.

In some embodiments of the present disclosure, the upper surface of the upper gate electrode material layer 1513 in the region overlapping the second active region 120 may be substantially coplanar with the upper surface of the upper gate electrode material layer 1513 in the region overlapping the third active region 130. In some embodiments of the present disclosure, the thickness (d5) of the upper gate electrode material layer 1513 in the region overlapping the second active region 120 may be thicker than the thickness (d6) of the upper gate electrode material layer 1513 in the region overlapping the third active region 130.

Referring to FIG. 3 and FIG. 16, the subsequent processes after forming the upper gate electrode material layer 1513 may be carried out in substantially the same manner as the method of manufacturing a memory device described with reference to FIG. 9 to FIG. 14.

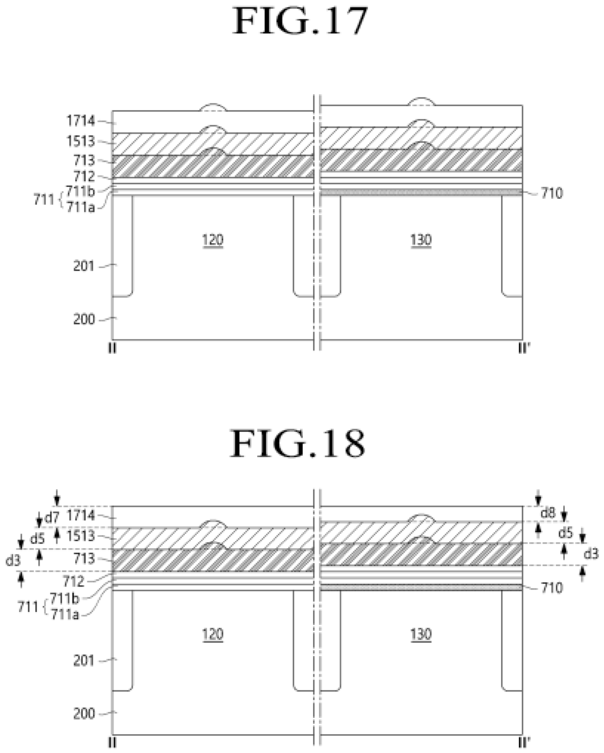

The memory device shown in FIG. 17 may be formed using substantially the same method as that described for manufacturing the memory device described with reference to FIG. 5 to FIG. 7 and FIG. 15.

Referring to FIG. 17, a gate capping material layer 1714 is formed on the upper gate electrode material layer 1513. In localized regions, for example, the central regions of the second active region 120 and the third active region 130, at least a portion of the gate capping material layer 1714 may protrude in a direction perpendicular to the upper surface of the substrate 200. The shape of the protruding portion is illustrated as semicircular but is not necessarily limited thereto and may vary depending on the shape of the lower gate electrode material layer 713.

Referring to FIG. 18, the upper portion of the gate capping material layer 1714 is removed, for example, by using a removing process including a chemical mechanical polishing process. According to an embodiment, this process may also remove the protruding portions of the gate capping material layer 1714.

In some embodiments of the present disclosure, the upper surface of the gate capping material layer 1714 in the region overlapping the second active region 120 may be substantially coplanar with the upper surface of the gate capping material layer 1714 in the region overlapping the third active region 130. In some embodiments of the present disclosure, the thickness (d7) of the gate capping material layer 1714 in the region overlapping the second active region 120 may be thicker than the thickness (d8) of the gate capping material layer 1714 in the region overlapping the third active region 130.

Referring again to FIG. 1 and FIG. 2, the first transistor disposed in the peripheral region (PR) of the substrate 200 includes a first gate insulating layer 211a, a first work function adjustment layer 212a, a first gate electrode 213a, and a first gate capping layer 214a. The second transistor disposed in the peripheral region (PR) of the substrate 200 includes a semiconductor layer 210, a second gate insulating layer 211b, a second work function adjustment layer 212b, a second gate electrode 213b, and a second gate capping layer 214b. The lower surface of the second gate insulating layer 211b is positioned higher than the lower surface of the first gate insulating layer 211a. The upper surface of the second gate capping layer 214b is positioned at the same height as the upper surface of the first gate capping layer 214a.

According to some embodiments of the present disclosure, in the process of forming the second lower gate electrode 213b1 and the second upper gate electrode 213b2, at least a portion (e.g., the upper portion) of the second lower gate electrode 213b1 or the second upper gate electrode 213b2 is removed. As a result, the thickness of the second lower gate electrode 213b1 may be thinner than that of the first lower gate electrode 213a1, or the thickness of the second upper gate electrode 213b2 may be thinner than that of the first upper gate electrode 213a2. Consequently, the distance from the upper surface of the second upper gate electrode 213b2 to the portion of the contact structure 222 located within the fourth insulating layer 221 is reduced, and interference between the second upper gate electrode 213b2 and the portion of the contact structure 222 within the fourth insulating layer 221 is minimized. According to some embodiments of the present disclosure, interference between adjacent metal layers can be minimized.

The above description illustrates various embodiments of the present invention. Various modifications and variations can be made by those skilled in the art without departing from the essential characteristics of the embodiments. The embodiments disclosed herein are not intended to limit the technical scope of the present disclosure but to describe it. Accordingly, the present invention is not limited by these embodiments. Furthermore, the embodiments may be combined to form additional embodiments.

## Claims

1. A memory device comprising:
a substrate including a cell region and a peripheral region;
a first transistor disposed in the peripheral region of the substrate, the first transistor including a first gate insulating layer, a first gate electrode, and a first gate capping layer; and
a second transistor disposed in the peripheral region of the substrate, the second transistor including a semiconductor layer, a second gate insulating layer having a lower surface positioned higher than a lower surface of the first gate insulating layer, a second gate electrode, and a second gate capping layer having an upper surface positioned substantially at the same height as an upper surface of the first gate capping layer.

2. The memory device of claim 1, wherein a thickness of the second gate electrode is thinner than a thickness of the first gate electrode.

3. The memory device of claim 2,
wherein the first gate electrode includes a first upper gate electrode and a first lower gate electrode,
wherein the second gate electrode includes a second upper gate electrode and a second lower gate electrode,
wherein the thicknesses of the first upper gate electrode and the second upper gate electrode are substantially the same, and
wherein the thickness of the second lower gate electrode is thinner than the thickness of the first lower gate electrode.

4. The memory device of claim 2,
wherein the first gate electrode includes a first upper gate electrode and a first lower gate electrode,
wherein the second gate electrode includes a second upper gate electrode and a second lower gate electrode,
wherein the thicknesses of the first lower gate electrode and the second lower gate electrode are substantially the same, and
wherein the thickness of the second upper gate electrode is thinner than the thickness of the first upper gate electrode.

5. The memory device of claim 4, wherein the second lower gate electrode includes a second lower gate planar portion and a second lower gate protruding portion extending from the second lower gate planar portion into the second upper gate electrode.

6. The memory device of claim 5, wherein the second lower gate protruding portion is spaced apart from the second gate capping layer.

7. The memory device of claim 1, wherein the thickness of the second gate capping layer is thinner than the thickness of the first gate capping layer.

8. The memory device of claim 7, wherein the second lower gate electrode comprises a second lower gate planar portion and a second lower gate protruding portion extending from the second lower gate planar portion into the second upper gate electrode.

9. The memory device of claim 8, wherein the second lower gate protruding portion is spaced apart from the second gate capping layer.

10. The memory device of claim 7, wherein the second upper gate electrode includes a second upper gate planar portion and a second upper gate protruding portion extending from the second upper gate planar portion into the second gate capping layer.

11. The memory device of claim 10, wherein the upper surface of the second upper gate protruding portion is positioned lower than the upper surface of the second gate capping layer.

12. The memory device of claim 1,
wherein the first gate insulating layer includes a first upper gate insulating layer and a first lower gate insulating layer,
wherein the second gate insulating layer includes a second upper gate insulating layer and a second lower gate insulating layer,
wherein the first upper gate insulating layer includes a material having a higher dielectric constant than the first lower gate insulating layer, and
wherein the second upper gate insulating layer includes a material having a higher dielectric constant than the second lower gate insulating layer.

13. The memory device of claim 1, wherein the semiconductor layer is an epitaxial layer.

14. A memory device comprising:
a substrate including a cell region and a peripheral region;
a first gate structure disposed in the peripheral region of the substrate, the first gate structure including a first gate insulating layer, a first gate electrode, and a first gate capping layer;
a second gate structure disposed in the peripheral region of the substrate, the second gate structure including a second gate insulating layer, a second gate electrode, and a second gate capping layer, and having a thickness thinner than that of the first gate structure; and
a semiconductor layer positioned between the substrate and the second gate structure.

15. The memory device of claim 14, wherein the thickness of the second gate electrode is thinner than the thickness of the first gate electrode.

16. The memory device of claim 15,
wherein the first gate electrode includes a first upper gate electrode and a first lower gate electrode,
wherein the second gate electrode includes a second upper gate electrode and a second lower gate electrode,
wherein the thicknesses of the first upper gate electrode and the second upper gate electrode are substantially the same, and
wherein the thickness of the second lower gate electrode is thinner than the thickness of the first lower gate electrode.

17. The memory device of claim 15,
wherein the first gate electrode includes a first upper gate electrode and a first lower gate electrode,
wherein the second gate electrode includes a second upper gate electrode and a second lower gate electrode,
wherein the thicknesses of the first lower gate electrode and the second lower gate electrode are substantially the same, and
wherein the thickness of the second upper gate electrode is thinner than the thickness of the first upper gate electrode.

18. The memory device of claim 14, wherein the thickness of the second gate capping layer is thinner than the thickness of the first gate capping layer.

19. The memory device of claim 14, wherein the upper surfaces of the first gate structure and the second gate structure are positioned substantially at the same height.

20. A memory device comprising:
first and second transistors disposed over adjacent active regions of a substrate, the first transistor including a first gate insulating layer, a first gate electrode, and a first gate capping layer, the second transistor including a semiconductor layer, a second gate insulating layer having a lower surface positioned higher than a lower surface of the first gate insulating layer, a second gate electrode, and a second gate capping layer having an upper surface positioned substantially at the same height as an upper surface of the first gate capping layer,
wherein a thickness of the second gate electrode is thinner than a thickness of the first gate electrode.
